# EUROPEAN PATENT APPLICATION

(11) **EP 4 836 596 A1**
(43) Date of publication of application: **04.11.2026**
(21) Application number: 24931849.4
(22) Date of filing: 26.03.2024
(51) Int. Cl.: H05K 1/03, H05K 1/02, H05K 1/11, H05K 3/46, H05K 3/40, H01L 23/525

(54) **PRINTED CIRCUIT BOARD AND PREPARATION METHOD FOR PRINTED CIRCUIT BOARD**

(71) Applicant: New H3C Technologies Co., Ltd., Hangzhou, Zhejiang 310052 (CN)
(72) Inventor: YANG, Zixiao, Beijing 100102 (CN); HU, Xinyi, Beijing 100102 (CN)
(74) Representative: 2SPL Patentanwälte PartG mbB
(86) International application number: PCT/CN2024/083902
(87) International publication number: WO 2025/199764

(57) **Abstract**

The present application provides a printed circuit board and a manufacturing method thereof. The printed circuit board includes a main body layer. The main body layer includes insulating film layers in a stack, where adjacent layers of the insulating film layers have different dielectric constants; the main body layer is provided with a through hole penetrating the main body layer, and the through hole include via holes respectively penetrating the insulating film layers; and among adjacent two insulating film layers of the insulating film layers, in one of the two insulating film layers, an average area of cross sections of the via hole perpendicular to a stacking direction of the insulating film layers is a first area, and a dielectric constant of the one of the adjacent two insulating film layers is a first dielectric constant; in the other one of the adjacent two insulating film layers, an average area of cross sections of the via hole perpendicular to a stacking direction of the insulating film layers is a second area, and a dielectric constant of the other one of the adjacent two insulating film layers is a second dielectric constant; where the first dielectric constant is greater than the second dielectric constant, and the first area is smaller than the second area.

## Description

### TECHNICAL FIELD

The present disclosure relates to circuit board technology, and in particular to a printed circuit board and a method of manufacturing a printed circuit board.

### BACKGROUND

Printed circuit boards are important electronic components, supports for electronic components, and providers of electrical connections for electronic components. With the development of electronic communication technology, the requirements for data transmission rate are gradually increasing, and the requirements for the signal transmission quality of printed circuit boards are also becoming higher and higher.

The impedance of signals during transmission is a key factor affecting the quality of signal transmission, and the impedance of signals during transmission in existing printed circuit boards needs to be optimized to achieve the purpose of improving signal transmission quality.

### SUMMARY

The present disclosure provides a printed circuit board and a method of manufacturing a printed circuit board.

The first aspect of embodiments of the present disclosure provides a printed circuit board. The printed circuit board includes:
a main body layer including a plurality of insulating film layers arranged in a stack, where dielectric constants of adjacent insulating film layers of the plurality of insulating film layers are different; the main body layer is provided with a through hole penetrating the main body layer, and the through hole include via holes respectively penetrating the plurality of the insulating film layers; among adjacent two of the plurality of the insulating film layers, in one of the adjacent two insulating film layers, an average area of cross sections of the via hole perpendicular to a stacking direction of the plurality of insulating film layers is a first area, and a dielectric constant of the one of the adjacent two insulating film layers is a first dielectric constant; in the other one of the adjacent two insulating film layers, an average area of cross sections of the via hole perpendicular to the stacking direction is a second area, and a dielectric constant of the other one of the adjacent two insulating film layers is a second dielectric constant; and where the first dielectric constant is greater than the second dielectric constant, and the first area is smaller than the second area.

In an embodiment, among adjacent two via holes of a same through hole, an orthographic projection of one of the two via holes onto a plane perpendicular to the stacking direction is a first projection, an orthographic projection of the other via hole onto the plane is a second projection, and the first projection falls within the second projection.

In an embodiment, the main body layer further includes a plurality of solder pads, one of the solder pads is arranged between adjacent two of the plurality of the insulating film layers, and the through hole further includes a contact hole penetrating the solder pad.

In an embodiment, an outer edge of an orthographic projection of the solder pad onto a plane perpendicular to the stacking direction is a first edge, and outer edges of orthographic projections of two via holes adjacent to the solder pad onto the plane are a second edge and a third edge respectively, and the second edge and the third edge are respectively inside the first edge.

In an embodiment, at least two insulating film layers of the plurality of the insulating film layers in the main body layer are made of a same material, and via holes of the insulating film layers made of the same material have basically a same average area of cross sections perpendicular to the stacking direction.

In an embodiment, a total quantity of the plurality of insulating film layers is an odd number, both sides of an insulating film layer in the middle are provided witha same quantity of insulating film layers, and two insulating film layers separated from the insulating film layer in the middle with a same quantity of insulating film layers have a same material and a same thickness.

In an embodiment, each cross section of a same via hole perpendicular to the stacking direction has basically a same shape and a same size.

In an embodiment, the insulating film layer includes a plurality of insulating material layers arranged in a stack, a total quantity of the plurality of insulating material layers in the main body layer is an odd number, and both sides of an insulating material layer in the middle are provided witha same quantity of insulating material layers; the via hole includes sub via holes respectively penetrating the plurality of insulating material layers; and in an insulating material layer on both sides of the insulating material layer in the middle, in a direction toward the insulating material layer in the middle, a cross-sectional area of the sub via hole of the insulating material layer perpendicular to the stacking direction gradually decreases.

In an embodiment, the main body layer further includes a plurality of solder pads, the solder pad is arranged between adjacent two of the plurality of the insulating material layers, and the through hole further includes a contact hole penetrating the solder pad.

In an embodiment, an outer edge of an orthographic projection of the solder pad onto a plane perpendicular to the stacking direction is a fourth edge, and outer edges of orthographic projections of two sub via holes adjacent to the solder pad onto the plane are a fifth edge and a sixth edge respectively, and the fifth edge and the sixth edge are respectively inside the fourth edge.

In an embodiment, the signal line includes at least one of a differential signal line or a single-ended signal line.

In an embodiment, the insulating film layers of the main body layer include a first insulating film layer and a second insulating film layer that are adjacent to each other, a dielectric constant of the first insulating film layer is greater than a dielectric constant of the second insulating film layer, the through hole includes a first via hole penetrating the first insulating film layer and a second via hole penetrating the second insulating film layer, an average area of cross sections of the first via hole perpendicular to the stacking direction is a first area, an average area of cross sections of the second via hole perpendicular to the stacking direction is a second area, and the first area is smaller than the second area;
the first insulating film layer and the second insulating film layer in the main body layer are alternately arranged; or,
the main body layer further includes a third insulating film layer, and a dielectric constant of a material of the third insulating film layer is smaller than a dielectric constant of a material of the second insulating film layer; the through hole further includes a third via hole penetrating the third insulating film layer; an average area of cross sections of the third via hole perpendicular to the stacking direction is a third area, and the third area is larger than the second area; the third insulating film layer is provided on a side of the second insulating film layer away from the first insulating film layer, or the third insulating film layer is provided on a side of the first insulating film layer away from the second insulating film layer.

The second aspect of embodiments of the present disclosure provides a method of manufacturing a printed circuit board, including:
forming a main body layer including a plurality of insulating film layers arranged in a stack; where dielectric constants of adjacent insulating film layers of the plurality of insulating film layers are different; the main body layer is provided with a through hole penetrating the main body layer, and the through hole include via holes respectively penetrating the plurality of the insulating film layers; among adjacent two of the plurality of the insulating film layers, in one of the adjacent two insulating film layers, an average area of cross sections of the via hole perpendicular to a stacking direction of the plurality of insulating film layers is a first area, and a dielectric constant of the one of the adjacent two insulating film layers is a first dielectric constant; in the one of the adjacent two insulating film layers, an average area of cross sections of the via hole perpendicular to the stacking direction is a second area, and a dielectric constant of the other one of the adjacent two insulating film layers is a second dielectric constant; and where the first dielectric constant is greater than the second dielectric constant, and the first area is smaller than the second area.

In an embodiment, forming a main body layer includes:
providing an intermediate structure including a first insulating film layer and two second insulating film layers on both sides of the first insulating film layer, where a dielectric constant of the first insulating film layer is smaller than a dielectric constant of the second insulating film layer;
forming an opening penetrating the main body layer, where each cross section of the opening perpendicular to a stacking direction of the plurality of insulating film layers has basically a same shape and a same size; and a portion of the opening in the first insulating film layer is a first via hole;
removing a material of an area in the second insulating film layer adjacent to the via hole, to form a second via hole, to make a cross-sectional area of the second via hole perpendicular to the stacking direction to be larger than a cross-sectional area of the first via hole perpendicular to the stacking direction.

In an embodiment, forming the opening penetrating the main body layer includes: drilling the main body layer by using a first drill bit, to form the opening penetrating the main body layer;

Removing the material of the area in the second insulating film layer adjacent to the via hole includes: drilling the second insulating film layer by using a second drill bit; where a maximum outer diameter of the second drill bit is greater than a maximum outer diameter of the first drill bit, and the second drill bit is partially in the opening when drilling.

In an embodiment, the main body layer includes two second insulating film layers and a first insulating film layer between the two second insulating film layers, a dielectric constant of the first insulating film layer is greater than a dielectric constant of the second insulating film layer, and forming the main body layer includes:
forming a first via hole penetrating the first insulating film layer;
providing the second insulating film layer on two opposite surfaces of the first insulating film layer respectively, bonding the first insulating film layer and the second insulating film layer, and forming a second via hole penetrating each second insulating film layer and connected with the first via hole;
   or,
the main body layer includes two first insulating film layers and a second insulating film layer between the two first insulating film layers, the dielectric constant of the first insulating film layer is greater than the dielectric constant of the second insulating film layer, and forming the main body layer includes:
forming a second via hole penetrating the second insulating film layer;
providing the first insulating film layer on two opposite surfaces of the second insulating film layer respectively, bonding the first insulating film layer and the second insulating film layer, and forming a first via hole penetrating each first insulating film layer and connected with the second via hole;

In an embodiment, bonding the first insulating film layer and the second insulating film layer includes:
performing lamination on the second insulating film layer and the first insulating film layer arranged in a stack, to bond the first insulating film layer and the second insulating film layer.

In an embodiment, the main body layer further includes a plurality of solder pads, the solder pad is arranged between adjacent two of the plurality of the insulating film layers, and the through hole further includes a contact hole penetrating the solder pad.

In an embodiment, an outer edge of an orthographic projection of the solder pad onto a plane perpendicular to the stacking direction is a first edge, and outer edges of orthographic projections of two via holes adjacent to the solder pad onto the plane are a second edge and a third edge respectively, and the second edge and the third edge are respectively inside the first edge.

In an embodiment, the insulating film layer includes a plurality of insulating material layers arranged in a stack; the via hole include a sub via hole penetrating each insulating material layer; the printed circuit board further includes a conductive structure in the through hole, the conductive structure includes a conductive portion in each of the sub via holes; and forming the main body layer and the conductive structure includes:
forming a sub via hole in an insulating material layer, and forming a conductive portion in the sub via hole;
repeating following steps until the main body layer and the conductive structure are formed:
providing an insulating material layer without any sub via hole respectively on two opposite surfaces of a structure obtained in the previous step, and bonding the insulating material layers arranged in a stack; and forming a sub via hole on the insulating material layer without any sub via hole, and forming a conductive portion in the sub via hole.

In an embodiment, the main body layer further includes a plurality of solder pads, the solder pad is arranged between adjacent two of the plurality of the insulating film layers, the through hole further includes a contact hole penetrating the solder pad, the contact hole and a sub via hole adjacent to the contact hole are formed synchronously, and the conductive portion is partially in the contact hole.

In an embodiment, the sub via hole is formed by using a laser etching process.

In an embodiment, providing an insulating material layer without any sub via hole respectively on two opposite surfaces of a structure obtained in the previous step, and bonding the insulating material layers arranged in a stack includes:
providing an insulating material layer respectively on both sides of the structure obtained in the previous step, and performing lamination on the insulating material layers arranged in a stack, to bond the insulating material layers arranged in a stack.

In an embodiment, a total quantity of the plurality of insulating material layers in the main body layer is an odd number, both sides of an insulating material layer in the middle are provided with a same quantity of insulating material layers, and two insulating material layers separated from the insulating material layer in the middle with a same quantity of insulating material layers have a same material and a same thickness.

In the printed circuit board and the method of manufacturing the printed circuit board provided by embodiments of the present disclosure, among adjacent two insulating film layers, in the insulating film layer with a larger dielectric constant, an average area of cross sections of the via hole perpendicular to a stacking direction of the insulating film layers is smaller, which helps to reduce the difference of the impedance of adjacent via holes, improve the continuity of the impedance of adjacent via holes, thereby reducing signal reflection during signal transmission, improving the return loss of through holes, and improving signal integrity. With the printed circuit board provided by embodiments of the present disclosure, by adjusting the size of via holes of different insulating film layers, the impedance of each via hole is basically the same, which effectively improves the signal integrity.

### BRIEF DESCRIPTION OF DRAWINGS

FIG. 1 is a partial cross-sectional view of a printed circuit board according to an exemplary embodiment of the present disclosure;
FIG. 2 is a top view of a partial structure of the printed circuit board illustrated in FIG. 1;
FIG. 3 is a partial cross-sectional view of a display panel according to another exemplary embodiment of the present disclosure;
FIG. 4 is a top view of a partial structure of the printed circuit board illustrated in FIG. 3;
FIG. 5 is a partial cross-sectional view of a printed circuit board according to another exemplary embodiment of the present disclosure;
FIG. 6 is a partial cross-sectional view of a printed circuit board according to another exemplary embodiment of the present disclosure;
FIG. 7 is a partial cross-sectional view of a printed circuit board according to another exemplary embodiment of the present disclosure;
FIG. 8 is a partial cross-sectional view of a printed circuit board according to another exemplary embodiment of the present disclosure;
FIG. 9 is a partial cross-sectional view of a printed circuit board according to another exemplary embodiment of the present disclosure;
FIG. 10 and FIG. 11 are result graphs obtained by simulating the printed circuit board illustrated in FIG. 5;
FIG. 12 is a partial cross-sectional view of a printed circuit board according to an exemplary embodiment of the present disclosure;
FIG. 13 is a flowchart of a manufacturing method of a printed circuit board according to an exemplary embodiment of the present disclosure;
FIG. 14 is a partial cross-sectional view of a first intermediate structure of a printed circuit board according to an exemplary embodiment of the present disclosure;
FIG. 15 is a partial cross-sectional view of a second intermediate structure of a printed circuit board according to an exemplary embodiment of the present disclosure;
FIG. 16 is a three-dimensional schematic diagram of a partial structure of a first intermediate structure of a printed circuit board according to an exemplary embodiment of the present disclosure;
FIG. 17 is a flowchart of a manufacturing method of a printed circuit board according to another exemplary embodiment of the present disclosure;
FIG. 18 is a partial cross-sectional view of a third intermediate structure of a printed circuit board according to an exemplary embodiment of the present disclosure;
FIG. 19 is a partial cross-sectional view of a fourth intermediate structure of a printed circuit board according to an exemplary embodiment of the present disclosure;
FIG. 20 is a flowchart of a manufacturing method of a printed circuit board according to another exemplary embodiment of the present disclosure;
FIG. 21 is a partial cross-sectional view of a fifth intermediate structure of a printed circuit board according to an exemplary embodiment of the present disclosure;
FIG. 22 is a partial cross-sectional view of a sixth intermediate structure of a printed circuit board according to an exemplary embodiment of the present disclosure;
FIG. 23 is a three-dimensional schematic diagram of a partial structure of a sixth intermediate structure of a printed circuit board according to an exemplary embodiment of the present disclosure;
FIG. 24 is a partial cross-sectional view of a seventh intermediate structure of a printed circuit board according to an exemplary embodiment of the present disclosure;
FIG. 25 is a partial cross-sectional view of an eighth intermediate structure of a printed circuit board according to an exemplary embodiment of the present disclosure;
FIG. 26 is a partial cross-sectional view of a ninth intermediate structure of a printed circuit board according to an exemplary embodiment of the present disclosure.

### DETAILED DESCRIPTION

Embodiments will be described in detail here, examples of which are illustrated in the accompanying drawings. When the following description relates to the accompanying drawings, unless specified otherwise, the same numerals in different drawings represent the same or similar elements. The implementations described in the following exemplary embodiments do not represent all implementations consistent with the present disclosure. Conversely, they are merely examples of apparatuses and methods consistent with some aspects of the present disclosure as detailed in the appended claims.

The terms used in this disclosure are merely for the purpose of describing specific embodiments, and are not intended to limit this disclosure. The terms "a", "said" and "the" of singular forms used in this application and the appended claims are also intended to include plural forms, unless the context clearly indicates otherwise. It should also be understood that, the term "and/or" used herein indicates and includes any or all possible combinations of one or more associated listed items.

It should be understood that although the terms such as first, second, and third may be used herein to describe various information, such information should not be limited to these terms. These terms are only used to distinguish information of the same category with each other. For example, without departing from the scope of the present disclosure, first information may be referred as second information; and similarly, second information may also be referred as first information. Depending on the context, the word "if" as used herein may be interpreted as "when" or "upon" or "in response to determining".

The printed circuit board includes a plurality of insulating film layers arranged in a stack and a plurality of signal lines, the printed circuit board is provided with a through hole, and a conductive structure is provided in the through hole, and a signal line is electrically connected to the conductive structure. The signal line may include a differential signal line, the through hole where a conductive structure connected to the differential signal line is located is a differential via hole, and the impedance of the differential via hole has a greater impact on the signal integrity of the signals transmitted by the differential signal line.

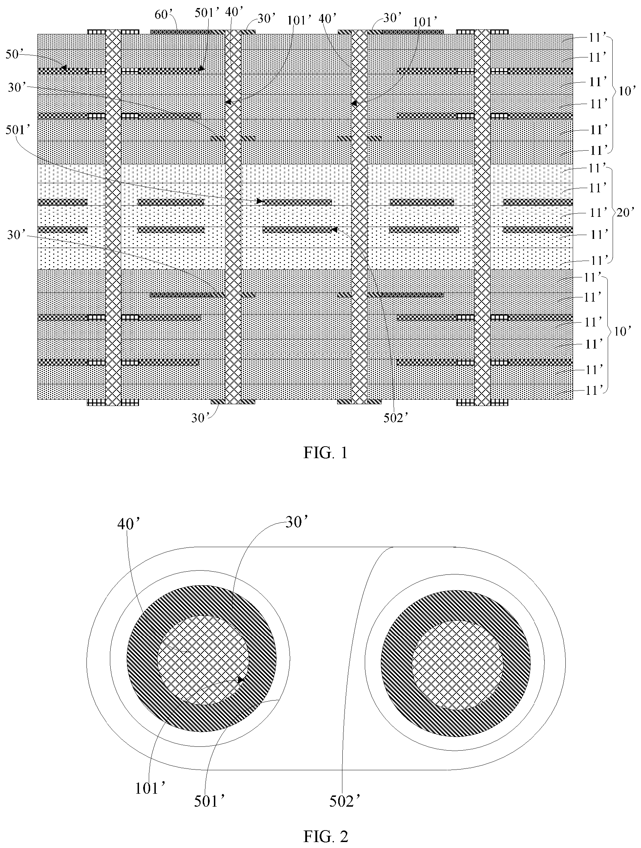

As illustrated in FIG. 1, the printed circuit board includes two first insulating film layers 10', one second insulating film layer 20', solder pads 30', conductive structures 40' and signal lines 60'. The second insulating film layer 20' is between the two first insulating film layers 10'. The first insulating film layer 10' and the second insulating film layer 20' each include a plurality of insulating material layers 11' arranged in a stack. A dielectric constant of a material of the first insulating film layer 10' is smaller than a dielectric constant of a material of the second insulating film layer 20'. Some solder pads 30' are on surfaces of the two first insulating film layers 10' away from the second insulating film layer 20', and some solder pads 30' are between adjacent two insulating material layers 11'. The printed circuit board is provided with differential via holes 101', and the apertures of the differential via holes 101' are basically the same everywhere; the differential via holes 101' include via holes penetrating each insulating material layer 11' and contact holes penetrating the pads 30', and the conductive structures 40' are in the differential via holes 101'. The signal line 60' is connected to the conductive structure 40' through the solder pad 30'. The printed circuit board further includes a plurality of conductive layers 50', a conductive layer 50' is provided between at least two adjacent insulating material layers 11' of the first insulating film layer 10', a conductive layer 50' is provided between at least two adjacent insulating material layers 11' of the second insulating film layer 20', the conductive layer 50' in the first insulating film layer 10' is provided with an antipad 501' corresponding to each conductive structure 40', and the conductive layer 50' in the second insulating film layer 20' is provided with an antipad 502' corresponding to each conductive structure 40'. In the present disclosure, the antipad is an opening penetrating a conductive layer. As illustrated in FIG. 2, the conductive structure 40' passes through the corresponding antipads 501' and antipads 502' to avoid the situation that the conductive layer 50' is in contact with the conductive structure 40'.

During the signal transmission process through the conductive structure, when the impedances of the via holes of each insulating film layer of the printed circuit board are the same or have very little difference, the signal reflection of the conductive structure during the signal transmission process may be effectively improved, which improves the return loss of differential via holes, and improves signal integrity. According to the total impedance requirements of the system including the printed circuit board and the electronic components connected to the printed circuit board, the target impedance of the via hole of each insulating film layer is determined. When the impedance of via holes of each insulating film layer is the same as or has very little difference from the target impedance, it helps to improve the signal quality.

The inventor found that, the greater the dielectric constant of the insulating film layer is, the smaller the impedance of the via hole of the insulating film layer is; the smaller the aperture of the via hole of the insulating film layer is, the smaller the impedance of the via hole of the insulating film layer is; and the larger the size of the antipad of the conductive layer in the insulating film layer is, the greater the impedance of the via hole of the insulating film layer is. By changing the aperture of via hole and the size of the antipad of the insulating film layer, the impedance of via hole of the insulating film layer may be adjusted.

In the printed circuit board illustrated in FIG. 1, the material of the first insulating film layer 10' is different from the material of the second insulating film layer 20'. The dielectric constant of the first insulating film layer 10' is 3, and the dielectric constant of the second insulating film layer 20' is 4, and the target impedance of the via hole of each insulating film layer is 92 ohms. If the size of the antipad of the conductive layer of the first insulating film layer 10' is the same as the size of the antipad of the conductive layer of the second insulating film layer 20', the impedance of the via hole of the first insulating film layer is less than the impedance of the via hole of the second insulating film layer. If the size of each antipad is not limited, the size of each antipad may be adjusted, such that the size of the antipad of the conductive layer of the second insulating film layer is larger than the size of the antipad of the conductive layer of the first insulating film layer, to reduce the difference between the impedance of the via hole of the first insulating film layer and the impedance of the via hole of the second insulating film layer, such that the impedance of the via hole of each insulating film layer is close to the target impedance. After optimizing the size of each antipad, a first printed circuit board is obtained. A simulation software is used to simulate the first printed circuit board and the following results are obtained: the range of the difference between the impedance of the via holes of each insulating film layer and the target impedance is -2 ohm ~ 2 ohm, when the frequency of the signal is in the range of 0~26.56GHz, the minimum return loss of the differential via hole is -25dB, and the signal integrity is relatively good. The size of each antipad in the first printed circuit board is referred to as the ideal size. The frequency of the signal in the range of 0~26.56GHz refers to the simulation at the basic frequency of 26.56GHz of the Ethernet 112G signal. The frequency of the signals mentioned below is the same.

However, in the design of printed circuit boards, the size of the antipad of the conductive layer is limited by the traces in the conductive layer, such as power signal lines. In order to avoid signal crosstalk and ensure the distance between traces adjacent to the antipad, a certain distance between the trace and the antipad needs to be ensured, such that the size of the antipad of the conductive layer in the second insulating film layer is smaller than the ideal size. The second printed circuit board is obtained by reducing the size of the antipad of the conductive layer in the second insulating film layer of the first printed circuit board to the minimum size allowed by the process. A simulation software is used to simulate the second printed circuit board and the following results are obtained: the maximum value of the impedance of the via hole of the first insulating film layer is 93 ohms, the minimum value of the impedance of the via hole of the second insulating film layer is 84.5 ohms, when the frequency of the signal is in the range of 0~26.56GHz, the maximum value of the return loss of the differential via hole is -16.5dB, and compared with the first printed circuit board, the signal integrity is significantly reduced.

Due to the low impedance of the via hole of the second insulating film layer, in order to further improve the signal quality, the structure of the printed circuit board is further improved to reduce the aperture of the differential via hole by 1 mil, to obtain the third printed circuit board. A simulation software is used to simulate the third printed circuit board and the following results are obtained: the minimum value of the impedance of the via hole of the second insulating film layer is 89.5 ohms, the maximum value of the impedance of the via hole of the first insulating film layer is 99.2 ohms, when the frequency of the signal is in the range of 0~26.56GHz, the maximum value of the return loss of the differential via hole is -13.2dB, and compared with the first printed circuit board, the signal quality is significantly reduced.

It may be found that the above-mentioned adjustments of the aperture of the differential via hole and the size of the antipad cannot effectively improve the signal quality.

The present disclosure provides a printed circuit board and a method of manufacturing a printed circuit board, which may improve the signal quality. The printed circuit board and the method of manufacturing the printed circuit board in embodiments of the present application will be described in detail below with reference to the accompanying drawings. If there is no conflict, features in the embodiments described below may complement each other or be combined with each other.

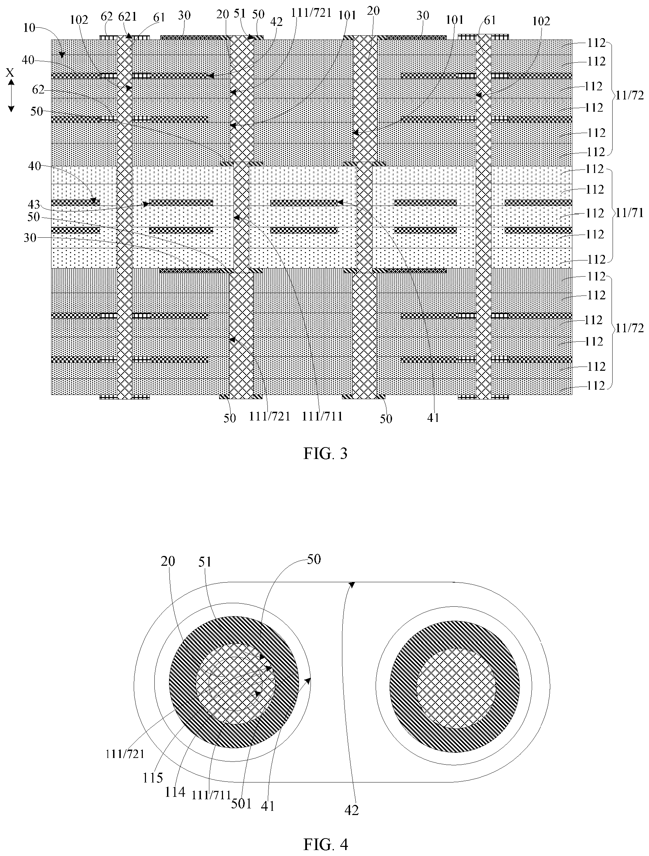

Embodiments of the present disclosure provides a printed circuit board. As illustrated in FIG. 3, the printed circuit board includes a main body layer 10, conductive structures 20, and signal lines 30.

The main body layer 10 includes a plurality of insulating film layers 11 arranged in a stack; materials of the adjacent insulating film layers 11 are different, and dielectric constants of the adjacent insulating film layers 11 are different; the main body layer 10 is provided with a through hole 101 penetrating the main body layer 10, and the through hole 101 include via holes 111 respectively penetrating the plurality of the insulating film layers 11; among adjacent two insulating film layers 11, in one of the two insulating film layers 11, the average area of cross sections of the via hole 111 perpendicular to a stacking direction X of the insulating film layers 11 is the first area, the dielectric constant is the first dielectric constant, in the other insulating film layer 11, the average area of cross sections of the via hole 111 perpendicular to the stacking direction is the second area, the dielectric constant is the second dielectric constant; the first dielectric constant is greater than the second dielectric constant, and the first area is smaller than the second area. When the respective areas of respective cross sections of the via hole 111 perpendicular to the stacking direction X are all the same, the areas of respective cross sections are all the same as the average area; and when the respective areas of respective cross sections of the via hole 111 perpendicular to the stacking direction X are not all the same, the average area is the average value of the areas of all the cross sections. The conductive structure 20 is in the through hole 101 of the main body layer 10 and completely fills the through hole 101. The signal line 30 is electrically connected with the conductive structure 20.

In the printed circuit board provided by embodiments of the present disclosure, among adjacent two insulating film layers, in the insulating film layer with a larger dielectric constant, the average area of the cross sections of the via hole perpendicular to a stacking direction of the insulating film layers is relatively small, which helps to reduce the difference of the impedance of the via holes in adjacent insulating film layers , improve the continuity of the impedance of adjacent via holes, thereby reducing signal reflection during signal transmission, improving the return loss of through holes, and improving signal integrity. With the printed circuit board provided by embodiments of the present disclosure, by adjusting the sizes of the via holes of different insulating film layers, the impedance of each via hole is basically the same, which effectively improves the signal integrity.

In an embodiment, the signal lines include at least one of a differential signal line or a single-ended signal line. The signal integrities of differential signal lines and single-ended signal lines are greatly affected by the impedance of the via holes. Designing the through holes where the conductive structure connected to a differential signal line or a single-ended signal line is located as the above structure may effectively improve signal integrity during the transmission. The through holes where the conductive structure connected to a differential signal line is located is a differential via hole. The main body layer may be provided with a plurality of pairs of differential via holes, and two differential via holes of the same pair of differential via holes are arranged adjacently. A single-ended signal line may be a parallel bus.

In an embodiment, as illustrated in FIG. 3, the first insulating film layer 11 and the second insulating film layer 12 both include a plurality of insulating material layers 112 arranged in a stack. The thickness of each insulating material layer of the same insulating film layer may be the same. Adjacent insulating material layers are in direct contact, and there is no space. The signal line 30 may be between adjacent two insulating material layers 112, or may be on the surface of the main body layer 10.

In an embodiment, as illustrated in FIG. 3, the main body layer 10 further includes a plurality of conductive layers 40, some conductive layers 40 are between adjacent two insulating material layers 112 of the first insulating film layer 11, some other conductive layers 40 are between adjacent two insulating material layers 112 of the second insulating film layer 12. The conductive layer 40 may also be between the first insulating film layer 11 and the second insulating film layer 12. The conductive layer 40 between the adjacent two insulating material layers 112 of the first insulating film layer 11 is provided with an antipad 41, and the conductive layer 40 between the adjacent two insulating material layers 112 of the second insulating film layer 12 is provided with an antipad 42, and each conductive layer is provided with an antipad corresponding to the conductive structure 20. The conductive structure 20 passes through the corresponding antipads 41 and antipads 42 to avoid the situation that the conductive layer 40 is in contact with the conductive structure 20 and a short circuit occurs. Adjacent two conductive structures 20 may pass through the same antipad 42. An insulating material layer fills an antipad 42. The conductive layer 40 may be a ground signal layer (GND layer), or may be a power signal layer (POWER layer).

In an embodiment, as illustrated in FIG. 3, the size of the antipad 41 provided on the conductive layer 40 between adjacent two insulating material layers 112 is smaller than the size of the antipad 42 provided on the conductive layer 40 between adjacent two insulating material layers 122. Such an arrangement also helps to reduce the difference in the impedance between adjacent two via holes.

In an embodiment, as illustrated in FIG. 3, adjacent two conductive structures 20 pass through the same antipad 42, that is, the corresponding antipads of the adjacent two conductive structures 20 are connected.

In an embodiment, the conductive structure 20 may completely fill the through hole 101 where the conductive structure is located. In other embodiments, the conductive structure 20 may be a hollow structure, and only cover the hole wall of the through hole 101 where the conductive structure is located.

In an embodiment, as illustrated in FIG. 3, the main body layer 10 is also provided with a return ground via hole 102, the return ground via hole 102 penetrates the main body layer 10, and the printed circuit board further includes a conductive material portion 61 in the return ground via hole 102. The return ground via hole 102 may reduce the return path of the signal transmitted by the conductive structure 20, which is beneficial to the control of the impedance of the via hole. Each cross section of the return ground via hole 102 perpendicular to the stacking direction X may has the same shape and the same size, for example, the return ground via hole 102 may be cylindrical.

In an embodiment, as illustrated in FIG. 3, the main body layer 10 may further include a solder pad structure 62, the two opposite surfaces of the main body layer 10 are respectively provided with solder pad structures 62 in one-to-one correspondence with the conductive material portions 61, the return ground via hole 102 further includes a contact hole 621 penetrating the pad structure 62, and the conductive material portion 61 is partially in the contact hole 621. Some solder pad structures 62 are arranged in the same layer as a ground signal layer, and the ground signal layer is connected to the solder pad structures 62 arranged in the same layer respectively, and the ground signal layer is electrically connected to a conductive material portion 61 through a solder pad structure 62. The solder pad structures 62 and the ground signal layer arranged in the same layer may be an integrated structure.

In an embodiment, as illustrated in FIG. 3, the main body layer 10 further includes a plurality of solder pads 50, the through hole 101 further includes a contact hole 51 penetrating the solder pad 50, the conductive structure 20 is in direct contact with the pad 50. Some of the solder pads 50 are connected to the signal lines 30, and a signal line 30 is electrically connected to a conductive structure 20 through a solder pad 50 connected thereto. The arrangement of the solder pads 50 facilitate the electrical connection between the signal lines 30 and the conductive structures 20.

In an embodiment, as illustrated in FIG. 3, the solder pads 50 are provided respectively the two opposite surfaces of the main body layer, the solder pads 50 on the same surface are in one-to-one correspondence with the conductive structures 20, and a conductive structure 20 is partially in the contact hole 51 of the corresponding solder pad 50. The surface of the conductive structure 20 and the surface of the solder pad 50 on the same side may be flush.

In an embodiment, as illustrated in FIG. 3, the solder pad 50 is provided between adjacent two insulating film layers 11. In this way, when an offset occurs in the center of adjacent two via holes 111, the portions of the conductive structure 20 in the adjacent two via holes 111 may be electrically connected through the solder pad 50, which helps to improve the electrical connection reliability of the portions of the conductive structure 20 in the adjacent two via holes 111.

In an embodiment, as illustrated in FIG. 4, the orthographic projection of the contact hole 51 of the solder pad 50 onto a plane perpendicular to the stacking direction X coincides with the orthographic projection of one of the via holes 111 adjacent to the solder pad toward the solder pad 50 onto the plane.

In an embodiment, as illustrated in FIG. 4, the outer edge of the orthographic projection of the solder pad 50 onto a plane perpendicular to the stacking direction is the first edge 501, and the outer edges of orthographic projections of two via holes 111 adjacent to the solder pad 50 onto the plane are the second edge 114 and the third edge 115 respectively, and the second edge 114 and the third edge 115 are respectively inside the first edge 501. In the embodiment illustrated in FIG. 4, the edge of the orthographic projection of the via hole with a larger average area on the plane is the second edge 114, and the orthographic projection of the via hole with a smaller average area on the plane is the third edge 115. With such an arrangement, even if a relative offset occurs in the geometric center of adjacent two via holes 111 due to process deviations during the manufacturing process, it may be ensured that the portions of the conductive structure 20 in adjacent two via holes 111 are in contact with the solder pad 50 between the two via holes 111 respectively, which ensures the electrical connection reliability of the portions of the conductive structure 20 in the adjacent two via holes 111.

In an embodiment, as illustrated in FIG. 3, among the solder pads 50 connected to the conductive structures 20 on the printed circuit board, some solder pads 50 are connected with a signal line 30. In other embodiments, each solder pad 50 of the main body layer 10 may all be connected with a signal line.

In an embodiment, among adjacent two via holes 111 of the same through hole 101, the orthographic projection of one of the two via holes 111 onto a plane perpendicular to the stacking direction is the first projection, the orthographic projection of the other via hole 111 onto the plane is the second projection, and the first projection falls within the second projection. That is, among adjacent two via holes 111 of the same through hole 101, the orthographic projection of the via hole 111 with a smaller average area onto the plane is the first projection, and the orthographic projection of the via hole 111 with a larger average area onto the plane is the second projection. Such an arrangement may enable the size of the solder pad 50 to be smaller, thereby reducing the impact of the solder pad 50 on the impedance of the via hole.

Further, each via hole 111 of the same through hole 101 is coaxial.

In an embodiment, as illustrated in FIG. 4, the cross section of the via hole 111 perpendicular to the stacking direction X is circular. In this way, the via hole 111 is easy to process, and the manufacturing process may be simplified. In other embodiments, the cross section of the via hole 111 perpendicular to the stacking direction X may be non-circular, e.g., may be rectangular, irregular, etc.

In an embodiment, at least two insulating film layers 11 in the main body layer 10 are made of the same material, and via holes of the insulating film layers 11 made of the same material have basically the same average area of cross sections perpendicular to the stacking direction X. Having basically the same average area means that the average areas are the same or have very little difference, for example, the average areas in the design are the same, but there is a little difference in the average areas due to process errors. With such an arrangement, the impedances of the via holes of the insulating film layers 11 made of the same material are basically the same, which helps to improve the signal quality.

In an embodiment, a total quantity of the insulating film layers 11 in the main body layer 10 is an odd number, both sides of an insulating film layer 11 in the middle have the same quantity of insulating film layers, and two insulating film layers 11 separated from the insulating film layer 11 in the middle with the same quantity of insulating film layers 11 have the same material and the same thickness. During the process of manufacturing a printed circuit board, a lamination process may be used to bond all the film layers of the main body layer, the above arrangement may make the forces on both sides of each insulating material layer being relatively balanced during the lamination process of the insulating material layer, which may prevent the insulating film layer in the middle from deforming and help to improve the quality of the printed circuit board.

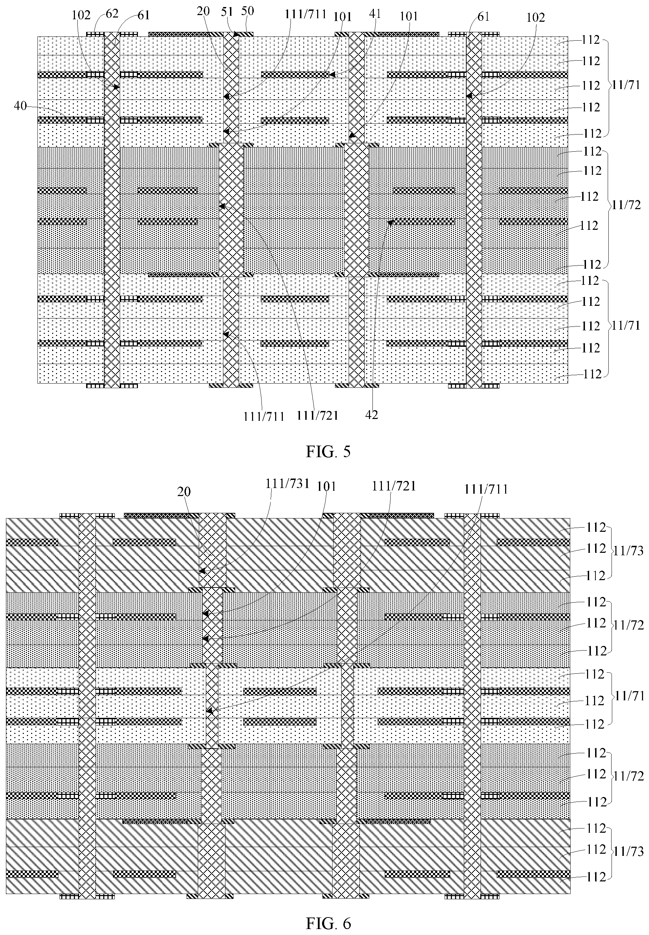

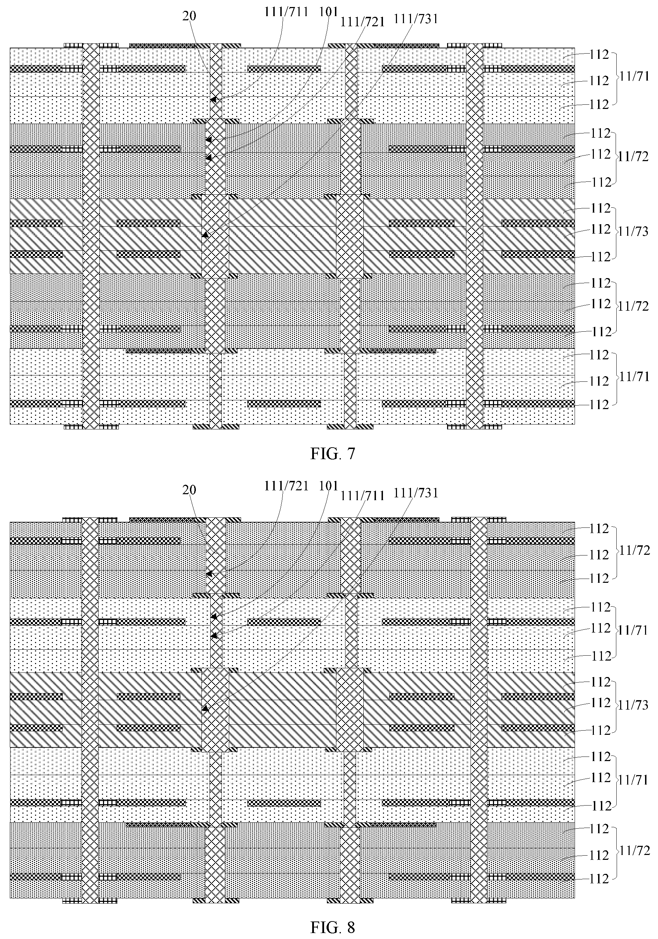

In the embodiment illustrated in FIG. 3, the main body layer 10 includes a first insulating film layer 71 and two second insulating film layers 72 on both sides of the first insulating film layer 71, the first insulating film layer 71 is the insulating film layer in the middle, the two second insulating film layers 72 are neither separated from the first insulating film layer 71 with any insulating film layer, and the two second insulating film layers 71 have the same material and the same thickness. In the embodiment illustrated in FIG. 5, the main body layer 10 includes two first insulating film layers 71 and a second insulating film layer 72 between the two first insulating film layers 71, the second insulating film layer 72 is the insulating film layer in the middle, the two first insulating film layers 71 are neither separated from the second insulating film layer 72 with any insulating film layer, and the two first insulating film layers 71 have the same material and the same thickness. In the embodiment illustrated in FIG. 6, the main body layer includes a first insulating film layer 71, two second insulating film layers 72, and two third insulating film layers 73; the two second insulating film layers 72 are between the two third insulating film layers 73, the first insulating film layer 71 is between the two second insulating film layers 72; the first insulating film layer 71 is the insulating film layer in the middle, the two second insulating film layers 72 are neither separated from the first insulating film layer 71 with any insulating film layer, and the two second insulating film layers 72 have the same material and the same thickness; and the two third insulating film layers 73 are both separated from the first insulating film layer 71 with an insulating film layer, and the two third insulating film layers 73 have the same material and the same thickness. In the embodiment illustrated in FIG. 7, the main body layer 10 includes a third insulating film layer 73, two second insulating film layers 72, and two first insulating film layers 71; the two second insulating film layers 72 are between the two first insulating film layers 71, the third insulating film layer 73 is between the two second insulating film layers 72; and the third insulating film layer 73 is the insulating film layer in the middle, the two second insulating film layers 72 have the same material and the same thickness, and the two first insulating film layers 71 have the same material and the same thickness.

Further, a plurality of conductive layers 40 in the main body layer 10 are symmetrically arranged on both sides of the insulating material layer in the middle. In this way, during the lamination process of the insulating material layers, the lamination forces on both sides of each insulating material layer and conductive layer are relatively balanced, which may prevent the film layers from deforming and help to improve the quality of the printed circuit board.

In an embodiment, as illustrated in FIG. 3, FIG. 5 to FIG. 8, each cross section of the same via hole 111 perpendicular to the stacking direction X has basically the same shape and the same size.

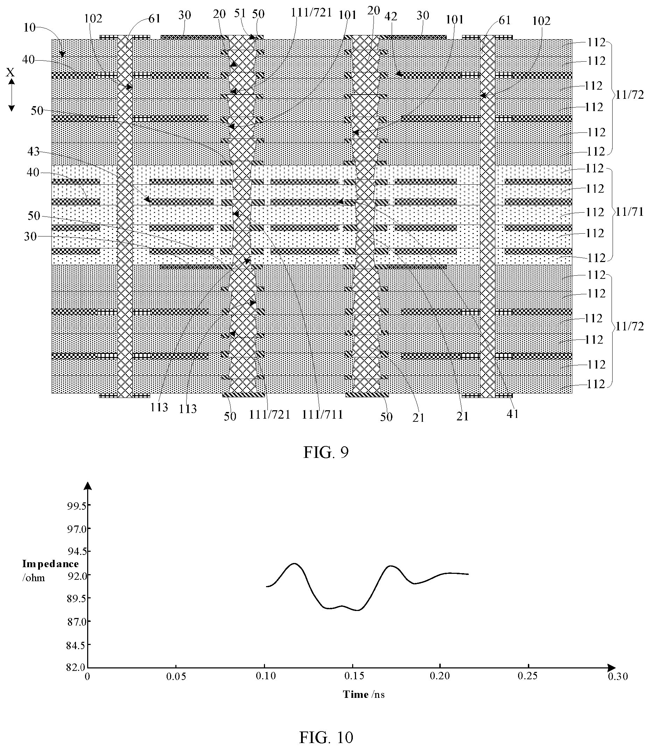

In another embodiment, as illustrated in FIG. 9, a total quantity of the insulating material layers 112 in the main body 10 layer is an odd number, and both sides of an insulating material layer 112 in the middle have the same quantity of insulating material layers 112; the via hole includes sub via holes 113 respectively penetrating the insulating material layers; and in an insulating material layer 112 on both sides of the insulating material layer 112 in the middle, in the direction toward the insulating material layer in the middle, a cross-sectional area of the sub via hole 113 perpendicular to the stacking direction X gradually decreases. The conductive structure 20 includes a plurality of conductive portions 21, and a conductive portion 21 is in a sub via hole 113. In this embodiment, different sub via holes 113 of the same via hole 111 are formed in different steps or the same step, and different conductive portions 21 of the same conductive structure 20 are formed in different process steps. The sub via hole 113 of each insulating material layer 112 may be formed by using a laser etching process.

Further, as illustrated in FIG. 9, a solder pad 50 is arranged between adjacent two of the insulating material layers 112, the through hole 101 further includes a contact hole 51 penetrating the solder pad 50, and the conductive structure 20 is in direct contact with the solder pad 50. By arranging a solder pad 50 between adjacent two insulating material layers, when an offset occurs in the center of adjacent two sub via holes 113, the adjacent two conductive portions 21 may be electrically connected through the solder pad 50, which may improve the electrical connection reliability of the adjacent two conductive portions 21.

Further, the outer edge of the orthographic projection of the solder pad 50 onto a plane perpendicular to the stacking direction X is a fourth edge, and the outer edges of orthographic projections of two sub via holes 113 adjacent to the solder pad 50 onto the plane are the fifth edge and the sixth edge respectively, and the fifth edge and the sixth edge are respectively inside the fourth edge. Such an arrangement may ensure the electrical connection reliability of adjacent two conductive portions.

In an embodiment, as illustrated in FIG. 9, at least one of the solder pads 50 is arranged in the same layer as the conductive layer 40, and the solder pad 50 is in an antipad of the conductive layer 40 arranged in the same layer.

In an embodiment, as illustrated in FIG. 3, FIG. 5 to FIG. 8, an insulating film layer of the main body layer 10 includes the first insulating film layer 71 and the second insulating film layer 72 which are adjacent to each other, the dielectric constant of the first insulating film layer 71 is greater than the dielectric constant of the second insulating film layer 72, the through hole 101 includes a first via hole 711 penetrating the first insulating film layer 71 and a second via hole 721 penetrating the second insulating film layer 72, the average area of cross sections of the first via hole 711 perpendicular to the stacking direction X is the first area, the average area of cross sections of the second via hole 721 perpendicular to the stacking direction X is the second area, and the first area is smaller than the second area.

In an embodiment, as illustrated in FIG. 3 and FIG. 5, the first insulating film layer 71 and the second insulating film layer 72 in the main body layer 10 are alternately arranged. In the embodiment illustrated in FIG. 3, the main body layer 10 includes two second insulating film layers 72 and a first insulating film layer 71 between the two second insulating film layers 72. In the embodiment illustrated in FIG. 5, the main body layer 10 includes two first insulating film layers 71 and a second insulating film layer 72 between the two first insulating film layers 71.

In an embodiment, as illustrated in FIG. 6 to FIG. 8, the main body layer 10 further includes a third insulating film layer 73, the material dielectric constant of the third insulating film layer 73 is greater than the dielectric constant of the material of the insulating film layer 71; the through hole 101 further includes the third via hole 731 penetrating the third insulating film layer 73; and the average area of cross sections of the third via hole 731 perpendicular to the stacking direction X is the third area, and the third area is smaller than the first area.

In the embodiments illustrated in FIG. 6 and FIG. 7, the third insulating film layer 73 is provided on a side of the second insulating film layer 72 away from the first insulating film layer 71. In the embodiment illustrated in FIG. 6, the main body layer 10 includes two second insulating film layers 72 and a first insulating film layer 71 between the two second insulating film layers 72, a third insulating film layer 73 is respectively provided on a side of the two second insulating film layers 72 away from the first insulating film layer 71, and in the direction toward the insulating film layer (i.e., the first insulating film layer 71) in the middle, the average area of the via hole 111 gradually decreases. In the embodiment illustrated in FIG. 7, the main body layer 10 includes two first insulating film layers 71, two insulating film layers 72 between the two first insulating film layers 71, and a third insulating film layer 73 between the two second insulating film layers 72, in a direction from the insulating film layer (i.e., the third insulating film layer 73) in the middle respectively to the insulating film layers on both sides, the average area of the via hole 111 gradually decreases. In the embodiment illustrated in FIG. 8, the third insulating film layer 73 is provided on a side of the first insulating film layer 71 away from the second insulating film layer 72, the main body layer 10 includes two first insulating film layers 71, the third insulating film layer 73 is between the two first insulating film layers 71, in a direction from the insulating film layer (i.e., the third insulating film layer 73) in the middle respectively to the insulating film layers on both sides, the average area of the via hole 111 first decreases and then increases.

It should be noted that, the drawings only take the main body layer including two or three insulating film layers with different dielectric constants as examples. The main body layer may include four or more insulating film layers with different dielectric constants, and the arrangement of the insulating film layers in the stacking direction may be selected according to needs.

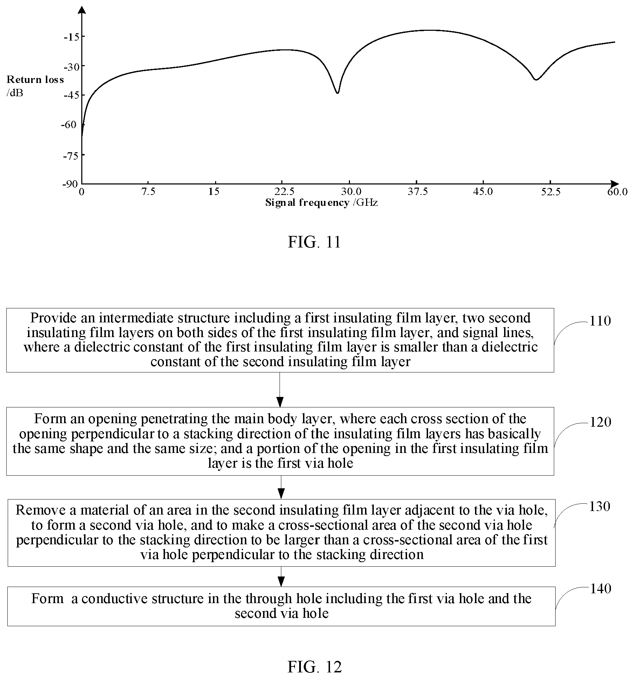

In order to verify the improvement effect for signal quality of the printed circuit board provided by embodiments of the present disclosure, a simulation software is used to simulate the via holes of the printed circuit board illustrated in FIG. 5 of the present disclosure. After simulation, the results are obtained as illustrated in FIG. 10 and FIG. 11. FIG. 10 is a graph illustrating the relationship between impedance and test time of the vole hole, and FIG. 11 is a graph illustrating the relationship between return loss and signal frequency. It may be seen that, according to FIG. 10 and FIG. 11, the minimum impedance of the via hole of the insulating film layer is 88.2 ohms, and the maximum impedance of the via hole is 93.3 ohms, and when the signal frequency is in the range of 0~26.56GHz, the minimum value of the return loss of the differential via holes is -21.6dB.

Compared with the second printed circuit board and the third printed circuit board, the printed circuit board illustrated in FIG. 5 of the present disclosure may significantly improve signal integrity. Among the second printed circuit board and the third printed circuit board, the signal quality of the third printed circuit board is better. According to the simulation result of the third printed circuit board, it can be seen that, the maximum value of the absolute value of the difference between the impedance of the via hole and the target impedance is 7.2 ohms, and the minimum value of the return loss of the differential via holes is -16.5dB; according to the simulation result of the printed circuit board illustrated in FIG. 5, it can be seen that, the maximum value of the absolute value of the difference between the impedance of the via hole and the target impedance is 3.8 ohms, and the minimum value of the return loss of differential via holes is -21.6dB. It may be obtained from calculation that, compared with the third printed circuit board, the printed circuit board illustrated in FIG. 5 may reduce the maximum value of the absolute value of the difference between the via impedance and the target impedance by 47%, and increase the return loss by 31%, which shows that the printed circuit board provided by an embodiment of the present disclosure may effectively improve signal integrity.

The present disclosure further provides a method of manufacturing a printed circuit board. The manufacturing method includes following steps: forming a main body layer including a plurality of insulating film layers arranged in a stack; where dielectric constants of the adjacent insulating film layers are different; the main body layer is provided with a through hole penetrating the main body layer, and the through hole include via holes respectively penetrating the plurality of the insulating film layers; among adjacent two of the insulating film layers, in one of the two insulating film layers, the average area of cross sections of the via hole perpendicular to a stacking direction of the insulating film layers is a first area, and a dielectric constant of the one of the adjacent two insulating film layers is a first dielectric constant; in the other one of the adjacent two insulating film layers, the average area of cross sections of the via hole perpendicular to the stacking direction is a second area, and the dielectric constant of the other one of the adjacent two insulating film layers is a second dielectric constant; and where the first dielectric constant is greater than the second dielectric constant, and the first area is smaller than the second area. The main body layer further includes a signal line. The manufacturing method further includes forming a conductive structure in the through hole. The signal line is electrically connected to the conductive structure.

### Embodiment 1

In this embodiment, the printed circuit board is the printed circuit board illustrated in FIG. 3. As illustrated in FIG. 12, the manufacturing method includes steps 110 to 140.

At step 110, an intermediate structure including a first insulating film layer, two second insulating film layers on both sides of the first insulating film layer, and signal lines is provided, and a dielectric constant of the first insulating film layer is smaller than a dielectric constant of the second insulating film layer.

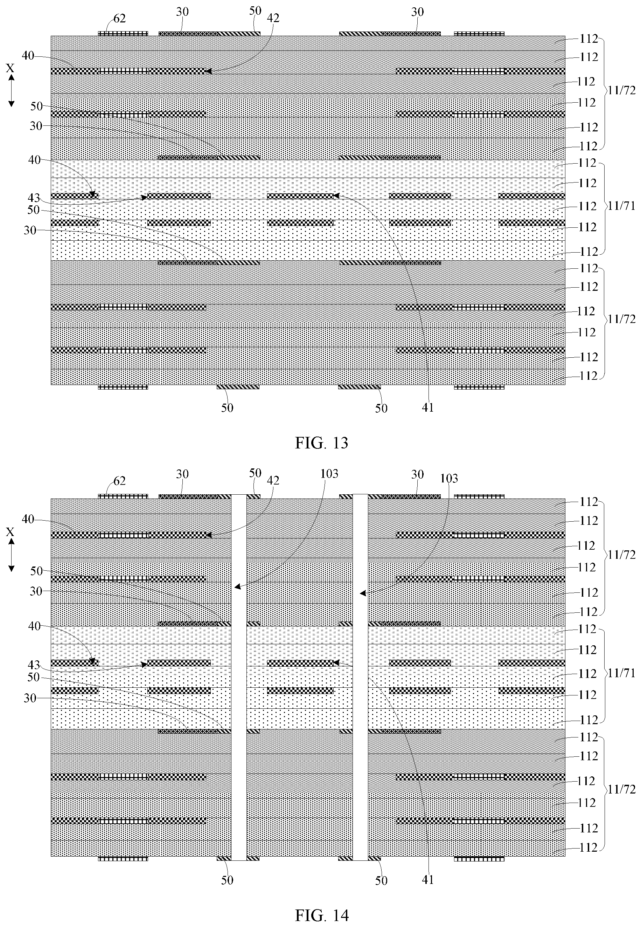

As illustrated in FIG. 13, the intermediate structure includes three insulating film layers 11: a first insulating film layer 71 and two second insulating film layers 72, the first insulating film layer 71 is between the two second insulating film layers 72; the first insulating film layer 71 and the second insulating film layers 72 each include a plurality of insulating material layers 112; the intermediate structure further includes a plurality of conductive layers 40, a plurality of solder pads 50, a plurality of solder pad structures 62, and a plurality of signal lines 30; each conductive layer 40 is between adjacent two insulating material layers 112, and the conductive layer 40 is provided with antipads 41 and antipads 42; between adjacent two insulating film layers 11, a solder pads 50 in one-to-one correspondence with the through holes 101 to be formed is provided, the solder pads 50 in one-to-one correspondence with the through holes 101 to be formed are respectively provided on two opposite surfaces of the intermediate structure; and at least one solder pad 50 is connected to the signal line 30. In this step, both the solder pad 50 and the solder pad structure 62 are conductive blocks without contact holes.

In an embodiment, the intermediate structure may be formed through the following steps: first, all the insulating material layers 112, the conductive layers 40, the solder pad structures 62 and the solder pads 50 of the main body layer are arranged in a stack, conductive layers are formed on surfaces of some insulating material layers 112, solder pads 50 are formed on surfaces of some insulating material layers 112, solder pad structures 62 are formed on surfaces of some insulating material layers 112, at least one solder pad is connected to the signal line and is on a surface of the same insulating material layer; then, the stacked insulating material layers are laminated, such that the insulating material layers 112 are bonded together, and adjacent two insulating material layers 112 are in direct contact, and the antipads 41 and antipads 42 of the conductive layer are filled with the adjacent insulating material layers.

At step 120, an opening penetrating the main body layer is formed, where each cross section of the opening perpendicular to a stacking direction of the insulating film layers has basically the same shape and the same size; and a portion of the opening in the first insulating film layer is the first via hole.

Through this step, the first intermediate structure may be obtained as illustrated in FIG 14. As illustrated in FIG. 14, the openings 103 penetrate each insulating film layer 11 and its corresponding pad 50.

In an embodiment, forming an opening penetrating the main body layer includes: drilling the main body layer by using a first drill bit, to form an opening penetrating the main body layer. By using the first drill bit, the process is simple and easy to implement, and the size of the opening 103 may be better controlled. After the opening 103 is formed by using the first drill bit, the cross section of the opening 103 perpendicular to the stacking direction X is substantially circular.

At step 130, a material of an area in the second insulating film layer adjacent to the via hole is removed, to form a second via hole, and to make a cross-sectional area of the second via hole perpendicular to the stacking direction to be larger than a cross-sectional area of the first via hole perpendicular to the stacking direction.

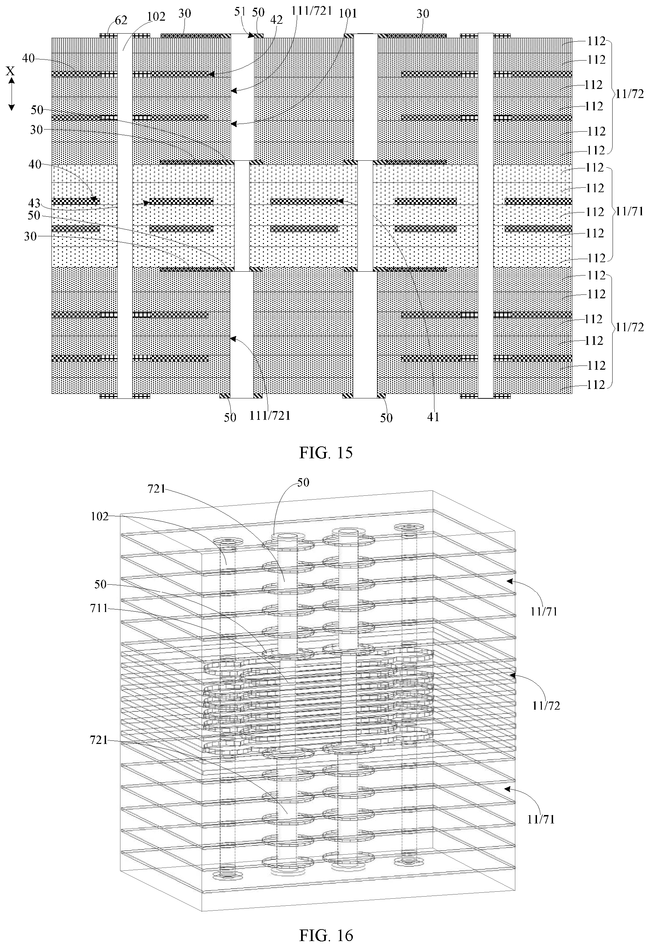

Through this step, the second intermediate structure as illustrated in FIG. 15 and FIG. 16, e.g., the main body layer, may be obtained. As illustrated in FIG. 15 and FIG. 16, the solder pad 50 is formed with a contact hole 51. The main body layer is further formed with a return ground via hole 102, the return ground via hole 102 may be formed before the second via hole is formed, or may be formed after the second via hole is formed.

In an embodiment, removing the material of the area in the second insulating film layer adjacent to the via hole, to form a second via hole includes: drilling the second insulating film layer by using a second drill bit, where the maximum outer diameter of the second drill bit is greater than the maximum outer diameter of the first drill bit, and the second drill bit is partially in the opening when drilling. Since the maximum outer diameter of the second drill bit is greater than the maximum outer diameter of the first drill bit, and the second drill bit is partially in the opening when drilling the second insulating film layer, the second drill bit may remove the material of the second insulating film layer adjacent to the opening.

In an embodiment, when the size of the contact hole 51 of the solder pad 50 is the same as the size of the adjacent first via hole 711, the portion of the opening in the solder pad 50 is the first via hole; when the size of the contact hole 51 of the solder pad 50 is the same as the size of the adjacent second via hole 712, when the second drill bit is used to drill the second insulating film layer 72, the second drill bit removes the material of the area in the solder pad 50 adjacent to the via hole, i.e., a contact hole is formed.

In an embodiment, the outer edge of the orthographic projection of the solder pad onto a plane perpendicular to a stacking direction of the insulating film layer is the first edge, the outer edges of orthographic projections of two via holes adjacent to the solder pad onto the plane are the second edge and the third edge respectively, and the second edge and the third edge are respectively inside the first edge.

At step 140, a conductive structure in the through hole including the first via hole and the second via hole is formed.

In an embodiment, an electroplating process may be used to form a conductive structure in through hole.

The method of manufacturing a printed circuit board through the above steps 110 to 140 requires only one lamination process, which helps to simplify the manufacturing process.

In an embodiment, the manufacturing method further includes: forming a conductive structure in a return ground via hole. The step of forming the conductive structure in the return ground via hole may be performed synchronously with step 140. Through this embodiment, the printed circuit board may be obtained as illustrated in FIG 3.

In an embodiment, the intermediate structure may further include a third insulating film layer on a side of each second insulating film layer away from the first insulating film layer, where the dielectric constant of the material of the third insulating film layer is smaller than the dielectric constant of the material of the second insulating film layer. The opening formed in step 120 penetrates the third insulating film layer; in step 130, the second drill bit simultaneously removes the areas of the third insulating film layers adjacent to the opening, to obtain a sub through hole in the third insulating film layer; after step 130, the method of manufacturing the printed circuit board further includes: using the third drill bit to drill the third insulating film layer, removing a material in an area of the third insulating film layer adjacent to the sub through hole, to form the third via hole penetrating the third insulating film layer; and the maximum outer diameter of the third drill bit is greater than the maximum outer diameter of the second drill bit. Through this embodiment, the printed circuit board illustrated in FIG 6 may be obtained.

### Embodiment 2

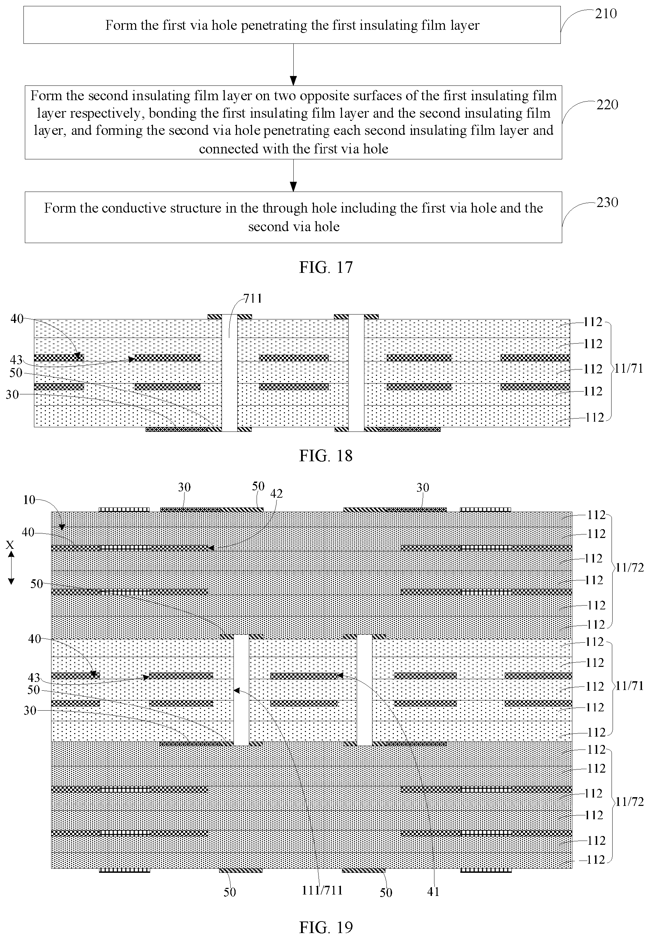

In this embodiment, the main body layer includes two second insulating film layers and a first insulating film layer between the two second insulating film layers, the dielectric constant of the first insulating film layer is greater than a dielectric constant of the second insulating film layer, and a signal line is provided on at least one surface of at least one of the first insulating film layer or the second insulating film layers. As illustrated in FIG. 17, the manufacturing method includes the following steps 210 to 230.

At step 210, a first via hole penetrating the first insulating film layer is formed.

Through this step, the third intermediate structure illustrated in FIG. 18 may be obtained. As illustrated in FIG. 18, the first insulating film layer 71 includes a plurality of insulating material layers 112 arranged in a stack; the third intermediate structure further includes a conductive layer 40, a signal line 30 and a solder pad 50, the conductive layer 40 is on opposite surfaces of the insulating film layer 71, two opposite surfaces of the first insulating film layer 71 are respectively provided with solder pads 50 and signal lines in one-to-one correspondence with the first via holes 711, the signal line 30 is connected to the solder pad 50, and the first via holes 711 penetrate each insulating material layer and corresponding solder pads 50.

In an embodiment, before step 210, the conductive layers 40, the signal lines 30, the solder pads 50, and the insulating material layers 112 are arranged in a stack, and then bonded together by using a lamination process.

In an embodiment, the first drill bit may be used to drill the first insulating film layer to form the first via hole.

At step 220, a second insulating film layer is provided on two opposite surfaces of the first insulating film layer respectively, the first insulating film layer and the second insulating film layer are bonded, and the second via hole penetrating each second insulating film layer is formed and connected with the first via hole.

In an embodiment, after bonding the first insulating film layer and the second insulating film layer, the fourth intermediate structure illustrated in FIG. 19 may be obtained. As illustrated in FIG. 19, the second insulating film layer 72 includes a plurality of insulating material layers 112, and the fourth intermediate structure further includes conductive layers 40 between adjacent insulating material layers of the second insulating film layer 72, and solder pads 50, signal lines 30, and a solder pad structure on the surface of the second insulating film layers 72.

In an embodiment, bonding the second insulating film layer and the first insulating film layer includes: arranging the second insulating film layer and the first insulating film layer in a stack, performing lamination, to bond the first insulating film layer and the second insulating film layer. Specifically, according to the stacking sequence of the film layers, the insulating material layer, conductive layer and solder pad of the second insulating film layer are respectively provided on two opposite surfaces of the third intermediate structure, and then lamination is performed.

After forming the second via hole and forming the return ground via hole in the second insulating film layer, the second intermediate structure illustrated in FIG. 15 and FIG. 16 may be obtained.

At step 230, a conductive structure in the through hole including the first via hole and the second via hole is formed.

In an embodiment, an electroplating process may be used to form a conductive structure.

Through this step, the printed circuit board illustrated in FIG 3 may be obtained.

In an embodiment, the manufacturing method further includes: forming a return ground via hole penetrating the main body layer; and forming a conductive structure in the return ground via hole. For a description of the steps of forming a return ground via hole and forming a conductive structure, please refer to Embodiment 1, which will not be described again here.

At step 230, before step 230, the manufacturing method of a printed circuit board may further include the following steps: providing a third insulating film layer on a side of the two second insulating film layers away from the first insulating film layer respectively, performing lamination, to bond the third insulating film layer and the second insulating film layer; forming the third via hole penetrating the third insulating film layer. In this embodiment, the through hole further includes a third via hole. Through this embodiment, the printed circuit board illustrated in FIG 6 may be obtained.

### Embodiment 3

This embodiment only describes the differences from Embodiment 2, and the similarities will not be described again.

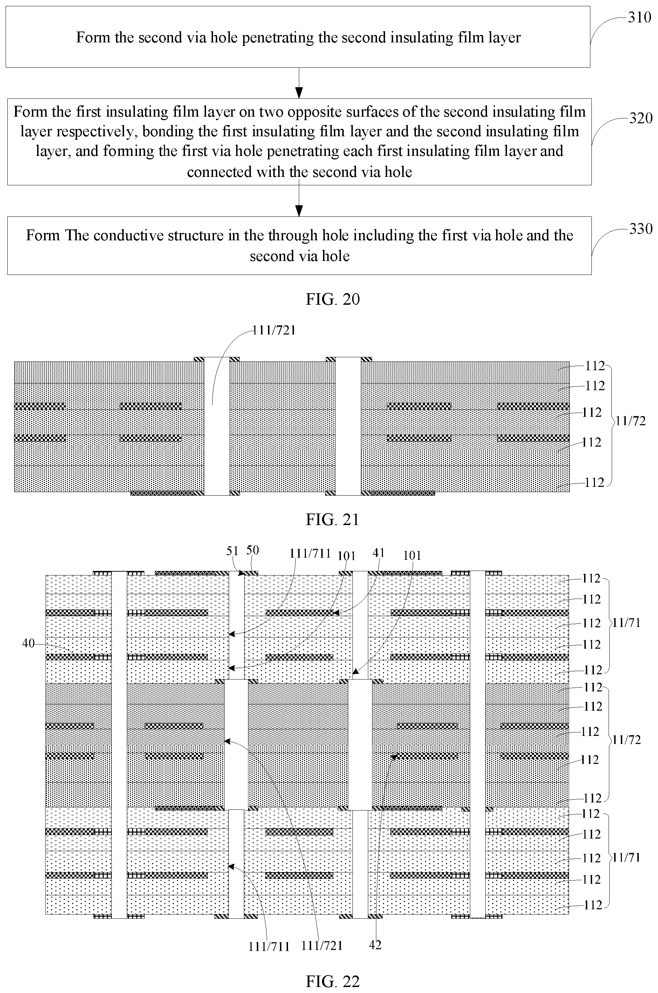

In this embodiment, the main body layer includes two first insulating film layers and a second insulating film layer between the two first insulating film layers. The dielectric constant of the material of the first insulating film layer of is greater than the dielectric constant of the second insulating film layer. As illustrated in FIG. 20, the manufacturing method includes the following steps 310 to 330. Only the differences from the previous embodiment will be introduced below, and the similarities will not be described again.

At step 310, the second via hole penetrating the second insulating film layer is formed.

Through this step, the fifth intermediate structure illustrated in FIG. 21 may be obtained.

At step 320, the first insulating film layer is provided on two opposite surfaces of the second insulating film layer respectively, the first insulating film layer and the second insulating film layer are bonded, and the first via hole penetrating each first insulating film layer is formed and connected with the second via hole.

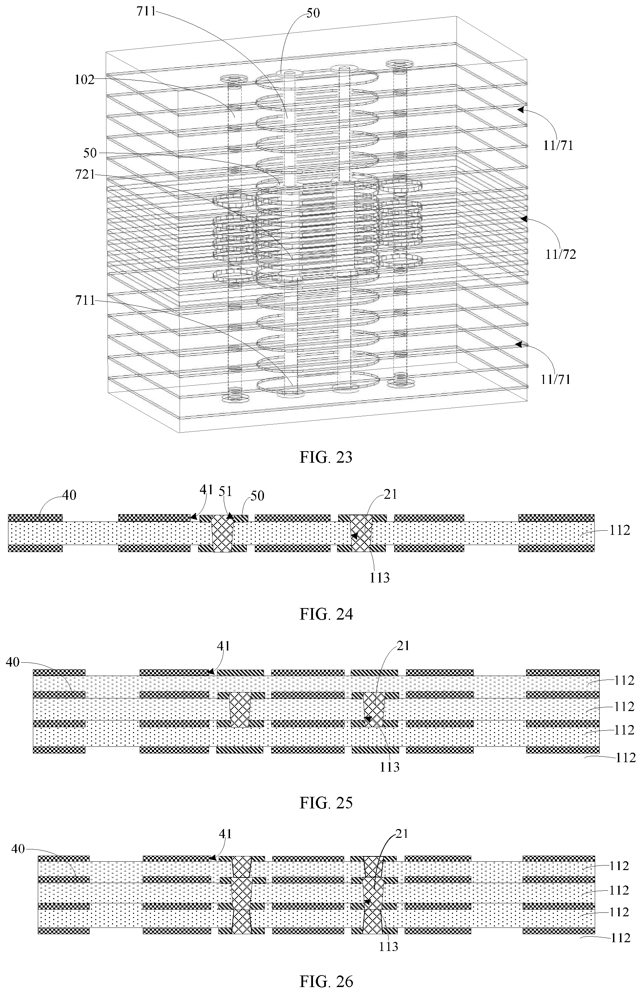

Through this step, the sixth intermediate structure illustrated in FIG. 22 and FIG. 23 may be obtained.

At step 330, a conductive structure in the through hole including the first via hole and the second via hole is formed.

Through this embodiment, the printed circuit board illustrated in FIG 5 may be obtained.

The manufacturing process of the printed circuit board illustrated in FIG. 7 and FIG. 8 is similar to Embodiment 3, and will not be described again.

### Embodiment 4

In this embodiment, the insulating film layer includes a plurality of insulating material layers arranged in a stack, at least one side of at least one of the insulating material layers is provided with a signal line; the via hole includes a sub via hole penetrating an insulating material layer; and the conductive structure includes a conductive portion in each of the sub via holes. The manufacturing method includes the following steps:
first, forming a sub via hole in an insulating material layer, and forming a conductive portion in the sub via hole;
then, repeating the following steps until the main body layer and the conductive structure are formed:
providing an insulating material layer without any sub via hole respectively on two opposite surfaces of a structure obtained in the previous step, and bonding insulating material layers arranged in a stack; and forming a sub via hole on the insulating material layer without any sub via hole, and forming a conductive portion in the sub via hole.

In an embodiment, an electroplating process may be used to form a conductive structure in through hole. First, an insulating material layer is respectively provided on two opposite surfaces of the structure obtained in the previous step, then, an opening is formed and a conductive portion is formed in the opening, which may enable the adjacent two conductive portions to have better contact and improve the electrical connection reliability of the adjacent conductive portions.

In an embodiment, a total quantity of the plurality of insulating material layers is an odd number, both sides of an insulating material layer in the middle have the same quantity of insulating material layers, and two insulating material layers separated from the insulating material layer in the middle with the same quantity of insulating material layers have the same material and the same thickness. The insulating material layer in which the sub via hole is formed first is the insulating material layer in the middle of the main body layer. In this way, in each lamination process, the forces on both sides of each insulating material layer are balanced, which can prevent the insulating material layer from deforming during the lamination process.

In an embodiment, an insulating material layer without any sub via hole is provided respectively on two opposite surfaces of a structure obtained in the previous step, and bonding insulating material layers arranged in a stack includes the following process: providing an insulating material layer respectively on both sides of a structure obtained in the previous step, and performing lamination on insulating material layers arranged in a stack, to bond the insulating material layers arranged in a stack. Specifically, according to the stacking sequence of the film layers, insulating material layers, solder pads, signal lines, and conductive layers are respectively provided on two opposite surfaces of a structure obtained in the previous step, and then lamination is performed on the film layers arranged in a stack.

In an embodiment, the main body layer further includes a plurality of solder pads, the solder pad is arranged between adjacent two of the plurality of the insulating material layers, the through hole further includes a contact hole penetrating the solder pad, and the conductive portion is partially in the contact hole.

In an embodiment, a total quantity of the plurality of insulating material layers is an odd number, both sides of an insulating material layer located in the middle have the same quantity of insulating material layers, and two insulating material layers separated from the insulating material layer in the middle with the same quantity of insulating material layers have the same material and the same thickness.

In an embodiment, in an insulating material layer on both sides of the insulating material layer in the middle, in the direction toward the insulating material layer in the middle, a cross-sectional area of the sub via hole of the insulating material layer perpendicular to the stacking direction gradually decreases.

Taking the printed circuit board illustrated in FIG. 9 as an example to describe the forming process of the printed circuit board.

First, a sub via hole is formed in an insulating material layer, and a conductive structure is formed in the sub via hole.

In this step, before forming the sub via hole in the insulating material layer, solder pads and conductive layers may be respectively provided on the two opposite surfaces of the insulating material layer, the solder pads and conductive layers on the same surface of the insulating material layer may be formed simultaneously, and a solder pad is in an antipad of the conductive layer. Through this step, the seventh intermediate structure illustrated in FIG. 24 may be obtained. As illustrated in FIG. 24, two opposite surfaces of the insulating material layer 112 are respectively provided with a solder pad 50 and a conductive layer 40; the solder pad 50 is formed with a contact hole 51, and the contact hole 51 is connected with a sub via hole 113; the conductive layer 40 is provided with an antipad 41, and a solder pad 50 on the same surface of the insulating material layer as the conductive layer 40 is in the antipad 41 of the conductive layer 40; the conductive portion 21 passes through the antipad 41, and a portion of the conductive portion 21 is in the contact hole 51.

In an embodiment, the contact hole 51 of the solder pad 50 and the sub via hole 113 are formed by using a laser etching process. In a direction from one surface of the insulating material layer 112 to the other surface, the area of the cross section of the conductive portion 21 parallel to the surface gradually increases.

Then, an insulating material layer is provided respectively on two opposite surfaces of an intermediate structure (i.e., the seventh intermediate structure) obtained in the previous step, the insulating material layers without any sub via hole and the insulating material layer with a sub via hole are bonded; and a sub via hole is formed on the insulating material layer without any sub via hole, and a conductive portion is formed in the sub via hole.

In this embodiment, after bonding the insulating material layers without any sub via hole and the insulating material layers with a sub via hole, the eighth intermediate structure illustrated in FIG. 25 may be obtained. As illustrated in FIG. 25, the surfaces of the insulating material layer 112 on both sides are respectively provided with the solder pads 50 and conductive layers 40.

A sub via hole is formed in an insulating material layer without any sub via hole, and a conductive portion is formed in the sub via hole, then the ninth intermediate structure illustrated in FIG. 26 may be obtained. As illustrated in FIG. 26, in an insulating material layer on both sides of the insulating material layer in the middle, in the direction toward the insulating material layer in the middle, a cross-sectional area of the sub via hole of the insulating material layer perpendicular to the stacking direction gradually decreases.

An insulating material layer is respectively provided on two opposite surfaces of a structure obtained in the previous step, and insulating material layers arranged in a stack are bonded; and a sub via hole is formed on the insulating material layer without any sub via hole, and a conductive portion is formed in the sub via hole. this step is repeated until the printed circuit board is obtained.

The embodiments of the method of manufacturing a printed circuit board and the embodiments of the printed circuit board provided in the embodiments of the present disclosure belong to the same inventive concept, the relevant details and descriptions of beneficial effects may refer to each other.

It is to be noted that in the accompanying drawings, the dimensions of layers and regions may be exaggerated for clarity of illustration. It will be understood that when an element or a layer is referred to as being "above" or "on" another element or layer, it may be directly on the other element, or intervening layers may be present. In addition, it will be understood that when an element or a layer is referred to as being "under" or "below" another element or layer, it may be directly under the other element, or one or more intervening layers or elements may be present. In addition, it will also be understood that when a layer or an element is referred to as being "between" two layers or two elements, it may be the only layer between the two layers or two elements, or one or more intervening layers or elements may be present. Like reference numerals indicate like elements throughout.

Those skilled in the art will readily conceive other embodiments of the present disclosure upon consideration of the specification and practice of the various embodiments disclosed herein. The present disclosure is intended to cover any variation, use, or adaptive change of this disclosure. These variations, uses, or adaptive changes follow the general principles of this disclosure and include common general knowledge or common technical means in the art that are not disclosed in this disclosure. The specification and the embodiments are considered as merely exemplary, and the real scope and spirit of the present disclosure are pointed out in the following claims.

It should be understood that this disclosure is not limited to the precise structures described above and illustrated in the accompanying drawings, and various modifications and changes may be made without departing from the scope of the present disclosure. The scope of the present disclosure is limited only by the appended claims.

## Claims

1. A printed circuit board, comprising:
a main body layer comprising a plurality of insulating film layers arranged in a stack;
wherein dielectric constants of adjacent insulating film layers of the plurality of insulating film layers are different;
the main body layer is provided with a through hole penetrating the main body layer, and the through hole comprises via holes respectively penetrating the plurality of the insulating film layers;
among adjacent two of the plurality of the insulating film layers, in one of the adjacent two insulating film layers, an average area of cross sections of the via hole perpendicular to a stacking direction of the plurality of insulating film layers is a first area, and a dielectric constant of the one of the adjacent two insulating film layers is a first dielectric constant; in the other one of the adjacent two insulating film layers, an average area of cross sections of the via hole perpendicular to the stacking direction is a second area, and a dielectric constant of the other one of the adjacent two insulating film layers is a second dielectric constant; wherein the first dielectric constant is greater than the second dielectric constant, and the first area is smaller than the second area.

2. The printed circuit board according to claim 1, wherein among adjacent two via holes of a same through hole, an orthographic projection of one of the two via holes onto a plane perpendicular to the stacking direction is a first projection, an orthographic projection of the other via hole onto the plane is a second projection, and the first projection falls within the second projection.

3. The printed circuit board according to claim 1, wherein the main body layer further comprises a plurality of solder pads, the solder pad is arranged between adjacent two of the plurality of the insulating film layers, and the through hole further comprises a contact hole penetrating the solder pad.

4. The printed circuit board according to claim 3, wherein an outer edge of an orthographic projection of the solder pad onto a plane perpendicular to the stacking direction is a first edge, and outer edges of orthographic projections of two via holes adjacent to the solder pad onto the plane are a second edge and a third edge respectively, and the second edge and the third edge are respectively inside the first edge.

5. The printed circuit board according to claim 1, wherein at least two insulating film layers of the plurality of the insulating film layers in the main body layer are made of a same material, and via holes of the insulating film layers made of the same material have basically a same average area of cross sections perpendicular to the stacking direction.

6. The printed circuit board according to claim 1, wherein a total quantity of the plurality of insulating film layers is an odd number, both sides of an insulating film layer in the middle are provided with a same quantity of insulating film layers, and two insulating film layers separated from the insulating film layer in the middle with a same quantity of insulating film layers have a same material and a same thickness.

7. The printed circuit board according to claim 1, wherein each cross section of a same via hole perpendicular to the stacking direction has basically a same shape and a same size.

8. The printed circuit board according to claim 1, wherein the insulating film layer comprises a plurality of insulating material layers arranged in a stack, a total quantity of the plurality of insulating material layers in the main body layer is an odd number, and both sides of an insulating material layer in the middle are provided with a same quantity of insulating material layers; the via hole comprises sub via holes respectively penetrating the plurality of insulating material layers; and in an insulating material layer on both sides of the insulating material layer in the middle, in a direction toward the insulating material layer in the middle, a cross-sectional area of the sub via hole of the insulating material layer perpendicular to the stacking direction gradually decreases.

9. The printed circuit board according to claim 8, wherein the main body layer further comprises a plurality of solder pads, the solder pad is arranged between adjacent two of the plurality of the insulating material layers, and the through hole further comprises a contact hole penetrating the solder pad.

10. The printed circuit board according to claim 9, wherein an outer edge of an orthographic projection of the solder pad onto a plane perpendicular to the stacking direction is a fourth edge, and outer edges of orthographic projections of two sub via holes adjacent to the solder pad onto the plane are a fifth edge and a sixth edge respectively, and the fifth edge and the sixth edge are respectively inside the fourth edge.

11. The printed circuit board according to claim 1, wherein the printed circuit board further comprises a signal line and a conductive structure in the through hole, the signal line is electrically connected to the conductive structure, and the signal line comprises at least one of a differential signal line or a single-ended signal line.

12. The printed circuit board according to claim 1, wherein the insulating film layers of the main body layer comprise a first insulating film layer and a second insulating film layer that are adjacent to each other, a dielectric constant of the first insulating film layer is greater than a dielectric constant of the second insulating film layer, the through hole comprises a first via hole penetrating the first insulating film layer and a second via hole penetrating the second insulating film layer, an average area of cross sections of the first via hole perpendicular to the stacking direction is a first area, an average area of cross sections of the second via hole perpendicular to the stacking direction is a second area, and the first area is smaller than the second area;
the first insulating film layer and the second insulating film layer in the main body layer are alternately arranged; or,
the main body layer further comprises a third insulating film layer, and a dielectric constant of a material of the third insulating film layer is smaller than a dielectric constant of a material of the second insulating film layer; the through hole further comprises a third via hole penetrating the third insulating film layer; an average area of cross sections of the third via hole perpendicular to the stacking direction is a third area, and the third area is larger than the second area; the third insulating film layer is provided on a side of the second insulating film layer away from the first insulating film layer, or the third insulating film layer is provided on a side of the first insulating film layer away from the second insulating film layer.

13. A method of manufacturing a printed circuit board, comprising:
forming a main body layer comprising a plurality of insulating film layers arranged in a stack;
wherein dielectric constants of adjacent insulating film layers of the plurality of insulating film layers are different;
the main body layer is provided with a through hole penetrating the main body layer, and the through hole comprises via holes respectively penetrating the plurality of the insulating film layers; among adjacent two of the plurality of the insulating film layers, in one of the adjacent two insulating film layers, an average area of cross sections of the via hole perpendicular to a stacking direction of the plurality of insulating film layers is a first area, and a dielectric constant of the one of the adjacent two insulating film layers is a first dielectric constant; in the other one of the adjacent two insulating film layers, an average area of cross sections of the via hole perpendicular to the stacking direction is a second area, and a dielectric constant of the other one of the adjacent two insulating film layers is a second dielectric constant; and where the first dielectric constant is greater than the second dielectric constant, and the first area is smaller than the second area.

14. The manufacturing method according to claim 13, wherein forming a main body layer comprises:
providing an intermediate structure comprising a first insulating film layer and two second insulating film layers on both sides of the first insulating film layer, wherein a dielectric constant of the first insulating film layer is smaller than a dielectric constant of the second insulating film layer;
forming an opening penetrating the main body layer, wherein each cross section of the opening perpendicular to a stacking direction of the plurality of insulating film layers has basically a same shape and a same size; and a portion of the opening in the first insulating film layer is a first via hole;
removing a material of an area in the second insulating film layer adjacent to the via hole, to form a second via hole, to make a cross-sectional area of the second via hole perpendicular to the stacking direction to be larger than a cross-sectional area of the first via hole perpendicular to the stacking direction.

15. The manufacturing method according to claim 14, wherein forming the opening penetrating the main body layer comprises: drilling the main body layer by using a first drill bit, to form the opening penetrating the main body layer;
removing the material of the area in the second insulating film layer adjacent to the via hole comprises: drilling the second insulating film layer by using a second drill bit; wherein a maximum outer diameter of the second drill bit is greater than a maximum outer diameter of the first drill bit, and the second drill bit is partially in the opening when drilling.

16. The manufacturing method according to claim 13, wherein the main body layer comprises two second insulating film layers and a first insulating film layer between the two second insulating film layers, a dielectric constant of the first insulating film layer is greater than a dielectric constant of the second insulating film layer, and forming the main body layer comprises:
forming a first via hole penetrating the first insulating film layer;
providing the second insulating film layer on two opposite surfaces of the first insulating film layer respectively, bonding the first insulating film layer and the second insulating film layer, and forming a second via hole penetrating each second insulating film layer and connected with the first via hole;
or,
the main body layer comprises two first insulating film layers and a second insulating film layer between the two first insulating film layers, the dielectric constant of the first insulating film layer is greater than the dielectric constant of the second insulating film layer, and forming the main body layer comprises:
forming a second via hole penetrating the second insulating film layer;
providing the first insulating film layer on two opposite surfaces of the second insulating film layer respectively, bonding the first insulating film layer and the second insulating film layer, and forming a first via hole penetrating each first insulating film layer and connected with the second via hole.

17. The manufacturing method according to claim 16, wherein bonding the first insulating film layer and the second insulating film layer comprises:
performing lamination on the second insulating film layer and the first insulating film layer arranged in a stack, to bond the first insulating film layer and the second insulating film layer.

18. The manufacturing method according to any one of claims 14 to 17, wherein the main body layer further comprises a plurality of solder pads, the solder pad is arranged between adjacent two of the plurality of the insulating film layers, and the through hole further comprises a contact hole penetrating the solder pad.

19. The manufacturing method according to claim 18, wherein an outer edge of an orthographic projection of the solder pad onto a plane perpendicular to the stacking direction is a first edge, and outer edges of orthographic projections of two via holes adjacent to the solder pad onto the plane are a second edge and a third edge respectively, and the second edge and the third edge are respectively inside the first edge.

20. The manufacturing method according to claim 13, wherein the insulating film layer comprises a plurality of insulating material layers arranged in a stack; the via hole comprise a sub via hole penetrating each insulating material layer; the printed circuit board further comprises a conductive structure in the through hole, the conductive structure comprises a conductive portion in each of the sub via holes; and forming the main body layer and the conductive structure comprises:
forming a sub via hole in an insulating material layer, and forming a conductive portion in the sub via hole;
repeating following steps until the main body layer and the conductive structure are formed:
providing an insulating material layer without any sub via hole respectively on two opposite surfaces of a structure obtained in the previous step, and bonding the insulating material layers arranged in a stack; and forming a sub via hole on the insulating material layer without any sub via hole, and forming a conductive portion in the sub via hole.

21. The manufacturing method according to claim 20, wherein the main body layer further comprises a plurality of solder pads, the solder pad is arranged between adjacent two of the plurality of the insulating material layers, the through hole further comprises a contact hole penetrating the solder pad, and the conductive portion is partially in the contact hole.

22. The manufacturing method according to claim 20, wherein the sub via hole is formed by using a laser etching process.

23. The manufacturing method according to claim 20, wherein providing the insulating material layer without any sub via hole respectively on two opposite surfaces of a structure obtained in the previous step, and bonding the insulating material layers arranged in a stack comprises:
providing an insulating material layer respectively on both sides of the structure obtained in the previous step, and performing lamination on the insulating material layers arranged in a stack, to bond the insulating material layers arranged in a stack.

24. The manufacturing method according to claim 23, wherein a total quantity of the plurality of insulating material layers in the main body layer is an odd number, both sides of an insulating material layer in the middle are provided with a same quantity of insulating material layers, and two insulating material layers separated from the insulating material layer in the middle with a same quantity of insulating material layers have a same material and a same thickness.
